**Europäisches Patentamt**

(19) **European Patent Office**

**Office européen des brevets**

(11) Veröffentlichungsnummer: **0 040 795**

**B1**

(12) # EUROPÄISCHE PATENTSCHRIFT

(45) Veröffentlichungstag der Patentschrift:
08.04.87

(51) Int. Cl.⁴: **H 01 L 27/20,** G 01 L 9/00

(21) Anmeldenummer: **81103843.9**

(22) Anmeldetag: **19.05.81**

(54) **Halbleiter-Sensor.**

(30) Priorität: **22.05.80  DE 3019674**

(43) Veröffentlichungstag der Anmeldung:
**02.12.81 Patentblatt 81/48**

(45) Bekanntmachung des Hinweises auf die Patenterteilung:
**08.04.87 Patentblatt 87/15**

(84) Benannte Vertragsstaaten:
**BE DE FR GB IT NL**

(56) Entgegenhaltungen:
**DE-A-2 822 509**
**FR-A-2 074 759**
**US-A-3 345 582**
**US-A-3 624 315**
**US-A-3 931 588**

(73) Patentinhaber: **Siemens Aktiengesellschaft Berlin und München, Wittelsbacherplatz 2, D-8000 München 2 (DE)**

(72) Erfinder: **Breimesser, Fritz, Dipl.- Ing., Dompfaffstrasse 49, D-8520 Erlangen (DE)**

LIBER, STOCKHOLM 1987

**Beschreibung**

Die vorliegende Erfindung betrifft einen Halbleiter-Sensor mit mehreren MIS-Transistoren, bei dem ein vorbestimmter Teil seiner Oberfläche als druckempfindlicher Bereich ausgebildet ist und bei dem wenigstens ein MIS-Transistor in diesem Bereich zur Umwandlung eines Druckes in ein elektrisches Signal vorgesehen ist.

Sensoren mit Frequenzausgang werden in der modernen Meßtechnik in zunehmendem Maße eingesetzt, da der Meßwert als Frequenz einfach übertragen und leicht digitalisiert werden kann.

Es ist bekannt, bei Halbleiter-Sensoren, welche den auf einen Teil ihrer Oberfläche (Membranbereich) wirkenden Druck in eine Frequenz umwandeln, im Membranbereich Widerstände bzw. Widerstandsbrücken als frequenzbestimmende Elemente auszubilden. Die Druckabhängigkeit der "bulk"-Ladungsträgerbeweglichkeit bei Widerständen ("piezoresistiver Effekt") kann dazu dienen, z.B. die Frequenz eines Oszillators in Abhängigkeit vom Druck zu verändern ("Solid-State Digital Pressure Transducer", von E.R. Peake et al, IEEE Transactions on Electron Devices, Oct. 1969; US-PS 3 345 582; Vortrag von Herrn Obermaier, Fraunhofer-Gesellschaft, auf der NTG-Diskussionssitzung "Sensoren und Leistungsstellglieder als Peripherie für Mikroprozessoren" vom 10. bis 12.10.1979 in Dinkelsbühl über einen Drucksensor). Diese bekannten Halbleiter-Sensoren erfordern elektronische Schaltungen, die entweder in hybrider Technik ausgeführt werden müssen oder deren Ausführung in integrierter Technik auf dem Halbleiter-Chip aufwendig ist.

Aus der deutschen Offenlegungsschrift DE-OS 28 22 509 ist ein Meßgerät bekannt, bei dem eine zu messende nichtelektrische Analoggröße in eine analoge Spannung umgewandelt wird, die mittels einer aus einer ungeraden Anzahl von Invertern aufgebauten freischwingenden Oszillatorschaltung in ein Frequenzsignal übergeführt wird. Die Schwingungsfrequenz dieser Oszillatorschaltung ist der an ihrer Stromeingangsklemme über einen Widerstand anliegenden Spannung proportional. Die zu messende nichtelektrische Analoggröße, beispielsweise die Temperatur, muß somit zunächst in einem außerhalb der Oszillatorschaltung befindlichen Schaltungsteil, beispielsweise eine Spannungsteilerschaltung, die einen Thermistor als temperatureimnfindliches Bauteil enthält, in eine analoge Spannung umgewandelt werden.

Aus der US-Patentschrift 3 624 315 ist weiterhin ein Wandler bekannt, bei dem die durch mechanische Spannungen im MIS-FET-Kanal eines MIS-Transistors bewirkte Änderung der Trägerbeweglichkeit verwendet wird, um eine mechanische Größe in eine elektrische Größe umzuwandeln. Zu diesem Zweck ist ein MIS-Transistor im beweglichen Bereich eines Silizium-Trägers angeordnet, dessen freies Ende starr mit einer Membran verbunden ist. Die auf die Membran einwirkenden Druckschwingungen bewirken eine Auslenkung der Membran und somit eine Schwingung des Silizium-Trägers, deren Amplitude der Amplitude der Druckschwingung entspricht. Der im beweglichen Bereich des Silizium-Trägers angeordnete MIS-Transistor ist mit einem ebenfalls aus MIS-FET-Transistoren aufgebauten wechselspannungsgekoppelten Verstärker verbunden, der in den starr mit einer Halterung verbunden unbeweglichen Teil des Silizium-Trägers integriert ist. Diese Anordnung ist somit nicht zur Messung eines statischen Druckes geeignet und die Frequenz des Ausgangssignals wird nur durch die Frequenz des auf die Membran wirkenden Drucksignals bestimmt.

Der Erfindung liegt die Aufgabe zugrunde, einen Halbleiter-Sensor anzugeben, welcher den auf den druckempfindlichen Bereich seiner Oberfläche wirkenden Druck in eine Frequenz umwandelt, bei dem solche Bauelemente Verwendung finden, die sehr einfache Schaltungen und eine hohe Druckempfindlichkeit ermöglichen.

Die Aufgabe wird erfindungsgemäß dadurch gelöst, daß im druckempfindlichen Bereich eines solchen Halbleiter-Sensors eine Schaltung mit MIS-Transistoren als frequenzbestimmenden Elementen ausgebildet ist.

In einer Ausbildung der Erfindung ist die druckabhängige Schaltgeschwindigkeit bei einer Anzahl von im druckempfindlichen Bereich ausgebildeten MIS-Transistoren die frequenzbestimmende Eigenschaft der in dieser Anzahl enthaltenen MIS-Transistoren.

In einer speziellen Ausbildung der Erfindung ist die druckabhängige Schaltgeschwindigkeit von im druckempfindlichen Bereich ausgebildeten MIS-Transistoren die frequenzbestimmende Eigenschaft dieser MIS-Transistoren, wobei MIS-Transistoren paarweise zu Invertern und eine ungerade Anzahl von diesen Invertern in Serie zu einem Ringoszillator geschaltet sind.

Durch Ausnutzen anisotroper Piezokoeffizienten im Membranbereich werden in einer weiteren Ausbildung der Erfindung Ringoszillatoren nach Anspruch 3 im durckempfindlichen Bereich so angeordnet, daß die jeweiligen druckabhängigen Frequenzänderungen unterschiedliches Vorzeichen aufweisen.

Um z.B. die Temperaturabhängigkeit der Ladungsträgerbeweglichkeit zu korrigieren, wird in einer weiteren Ausbildung der Erfindung außerhalb des druckempfindlichen Bereiches ein weiterer Ringoszillator entsprechend Anspruch 3 angeordnet, dessen Ausgangsfrequenz als Referenzgröße für die Auswertung der druckabhängigen Frequenzen verwendet wird.

Eine weitere Ausbildung der Erfindung besteht darin, daß der Halbleiter-Sensor in integrierter Technik ausgeführt wird.

Um für Telemetrie-Zwecke, z.B. die Frequenzen durch geeignete Vervielfacher-Schaltungen in höhere Frequenzbereiche zu transformieren oder um die Frequenzen mit Hilfe von Frequenzteilern, die z.B. mit Digitalzählern realisiert werden, in niedrigere Bereiche umzusetzen, sind in einer weiteren Ausbildung der Erfindung auf der Oberfläche des Halbleiter-Sensors Schaltungen in integrierter Technik vorhanden, die die Frequenz(en) des bzw. der Ringoszillators(en) in einen vom Anwender gewünschten Bereich umsetzen.

Niedrige Ausgangsfrequenzen werden bei längeren Übertragungsstrecken bevorzugt.

Um die Auswirkungen von unterschiedlichen thermischen Ausdehnungskoeffizienten gering zu halten, ist nach einer weiteren Ausbildung der Erfindung der Halbleiter-Sensor ein in Silizium-Gate-Technik ausgeführter Silizium-Sensor.

Die mit der Erfindung erzielbaren Vorteile bestehen darin, daß MIS-Transistoren auf kleinstem Raum ausgebildet werden können, daß wegen der Vielzahl der Verwendungsmöglichkeiten von MIS-Transistoren sehr einfache Schaltungen ausgeführt werden können, daß bei Anwendung einer integrierten Technik die Ausführung dieser Schaltungen sehr einfache geometrische Strukturen zuläßt und daß bei entsprechender Wahl der Kristallorientierung, der Anordnung der frequenzbestimmenden MIS-Transistoren im druckempfindlichen Bereich und der von der Ausgestaltung dieser MIS-Transistoren abhängigen Oberflächen-Energiebandstruktur eine hohe Druckempfindlichkeit des Halbleiter-Sensors erreicht wird.

Ausführungsbeispiele der Erfindung sind in der Zeichnung dargestellt und werden im folgenden näher beschrieben.

FIG 1 zeigt die Schaltung eines PELS-Inverters,

FIG 2 zeigt die Schaltung eines Ringoszillators mit drei PELS-Invertern,

FIG 3 zeigt die geometrische Struktur einer Serienschaltung von PELS-Invertern im druckempfindlichen Bereich eines Halbleiter-Sensors in der Draufsicht,

FIG 4 zeigt die Schaltung eines Inverters mit komplementären MIS-Transistoren (sog. "CMOS-Inverter").

Einzelheiten über MIS-Transistoren und über MIS-Transistoren anwendbare Techniken können dem Buch "MOS/ LSI-Design an Application" von W.N. Carr und J.P.Mize, McGraw-Hill Book Comp., New York, 1972, entnommen werden. Grundsätzlich sind p- und n-Kanal-MIS-Transistoren und Kombinationen daraus ("CMOS") verwendbar. Das folgende Beispiel dient zur Erläuterung; es arbeitet mit p-Kanal-Elementen, da die Druckabhängigkeit der p-Ladungsträgerbeweglichkeit i.a. besonders groß ist.

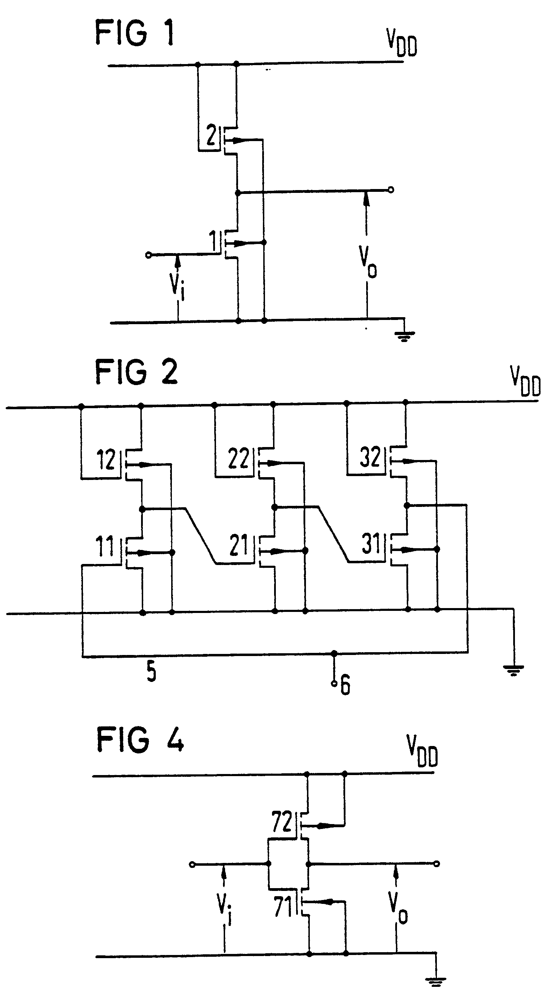

FIG 1 zeigt die Schaltung eines PELS-Inverters (PELS = p-channel enhancement-type load, saturation region of operation). Der PELS-Inverter weist einen Schalttransistor 1 und einen Lasttransistor 2 auf. Drain und Gate des Lasttransistors 2 sind an dieselbe Versorgungsspannung $V_{DD}$ angeschlossen. Source des Schalttransistors 1 ist geerdet. Das Eingangspotential $V_i$ des Inverters liegt am Gate des Schalttransistors 1, das Ausgangspotential $V_o$ des Inverters wird an der Verbindung zwischen Drain des Schalttransistors 1 und Source des Lasttransistors 2 abgenommen. Bei einem PELS-Inverter sind beide Transistoren 1, 2 p-Kanal-Anreicherungs-MIS-Transistoren.

Der Lasttransistor 2 dient als Lastwiderstand. Ein MIS-Transistor benötigt wenig Platz: Ein MIS-Lasttransistor von 100 k Ohm nimmt eine Fläche von ungefähr 0,0006 mm² ein. Der Lasttransistor 2 wird im Sättigungsbereich betrieben, was die Verwendung nur einer Versorgungsspannung $V_{DD}$ ermöglicht. Liegt die Eingangsspannung $V_i$ des Inverters unterhalb der Schwellenspannung des Schalttransistors, so entspricht die Ausgangsspannung $V_o$ des Inverters ihrer Größe nach in etwa der Versorgungsspannung $V_{DD}$. Liegt die Eingangsspannung $V_i$ oberhalb dieser Schwellenspannung, so erreicht die Ausgangsspannung $V_o$ ihrer Größe nach in etwa den Wert Null.

FIG 2 zeigt die Schaltung eines Ringoszillators mit drei PELS-Invertern. Drei PELS-Inverterstufen sind in Serie geschaltet; die Ausgangsspannung einer jeden Stufe dient als Eingangsspannung für die folgende Stufe. Die Schalttransistoren der drei Inverterstufen sind mit 11, 21, 31, die zugehörigen Lasttransistoren mit 12, 22, 32 bezeichnet. Um eine Serienschaltung von Invertern als Ringoszillator betreiben zu können, ist eine ungerade Anzahl von Invertern notwendig. Am Anschluß 6 an der Rückkopplungsleitung 5 des Ringoszillators kann die Oszillatorfrequenz als ein Maß für den auf den druckempfindlichen Bereich wirkenden Betrag des Druckes abgegriffen werden.

Die Frequenz $f_{Osz}$ des Ringoszillators kann man ungefähr angeben:

$$f_{Osz} \simeq \frac{1}{n \cdot (t_{PLH} + t_{PHL})}$$

mit n... ungerade Anzahl von Invertern

$t_{PLH}$ Laufzeit eines Inverters vom Zustand L ("low") zum Zustand H ("high")

$t_{PHL}$ Laufzeit eines Inverters vom Zustand H zum Zustand L.

Die Frequenz $f_{Osz}$ ist eine Funktion der Inverterschaltgeschwindigkeiten. Die Frequenz $f_{Osz}$ befindet sich ungefähr im MHz-Bereich.

Der effektive Lastwiderstand eines PELS-Inverters ist relativ groß, weil der Lasttransistor im Sättigungsbereich betrieben wird. Dieser Effekt verkleinert von vornherein die Frequenz $f_{Osz}$ im Vergleich zum Beispiel zu einem PELT-Inverter (PELT = p-channel enhancement-type load, triode region of operation).

Die Schaltgeschwindigkeiten eines PELS-Inverters werden insbesondere dadurch druckabhängig, daß die Schaltgeschwindigkeit eines Schalttransistors ungefähr proportional zur Oberflächen-Ladungsträgerbeweglichkeit ist, die wiederum vom Druck beeinflußt wird. Dazu kommt noch die Druckabhängigkeit der Oberflächen-Ladungsträgerbeweglichkeit beim Lasttransistor.

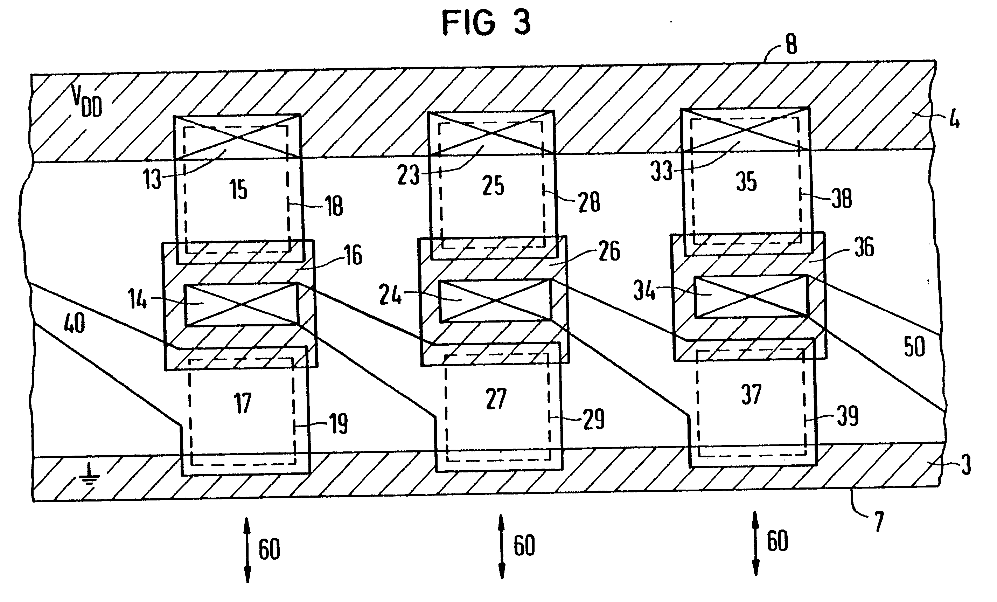

FIG 3 zeigt die geometrische Struktur einer Serienschaltung von PELS-Invertern im druckempfindlichen Bereich eines Halbleiter-Sensors in der Draufsicht. Als Substrat wird n-dotiertes Halbleitermaterial verwendet, in dem p-dotierte Gebiete (schraffiert gekennzeichnet) durch eine der üblichen Techniken ausgebildet sind. Mit 3 wird das geerdete p-Gebiet bezeichnet, in dem sich die jeweiligen Sources der Schalttransistoren befinden. Mit 4 wird das auf dem Potential $V_{DD}$ liegende p-Gebiet bezeichnet, in dem sich die jeweiligen Drains der Lasttransistoren befinden. In den Kontaktbereichen 13, 23, 33 sind die Gates 15, 25, 35 der Lasttransistoren

3

leitend mit dem p-Gebiet 4 verbunden. Bei den einzelnen Inverterstufen sind Drain des Schalttransistors und Source des Lasttransistors zu gemeinsamen p-Gebieten 16, 26, 36 zusammengefaßt. Die Isolierung der Gate-Bereiche 15, 17, 25, 27, 35, 37 erfolgt über die Gate-Oxidschichten 18, 19, 28, 29, 38, 39, die in der Zeichnung gestrichelt umrandet sind. Von dem jeweiligen Kontaktbereich 14, 24, 34 der einzelnen Inverter ausgehend gibt es eine elektrische Verbindung zu dem jeweiligen Gate 17, 27, 37 des Schalttransistors der folgenden Inverterstufe. Der Halbleiter-Sensor wird in diesem Beispiel in der Draufsicht nach zwei Seiten hin der Einfachheit halber von den Geraden 7, 8 begrenzt. Als Begrenzung des Halbleiter-Sensors in der Draufsicht sind auch andere geometrische Strukturen möglich, z.B. Kreisringe oder Segmente davon. Wäre der Halbleiter-Sensor nach den beiden anderen Seiten hin nicht abgebrochen gezeichnet, so würde zu erkennen sein, daß die Leitung 40 von der letzten Inverterstufe des Halbleiter-Sensors her kommt und daß die Leitung 50 zur nächstfolgenden Inverterstufe des Halbleiter-Sensors führt.

Die Richtung der Druckempfindlichkeit 60 der Inverter ist in der Zeichnung angegeben. Sie ist auf den druckempfindlichen Bereich des Halbleiter-Sensors abzustimmen.

In einer weiteren Ausführung der Erfindung kann man beispielsweise CMOS-Inverter verwenden.

FIG 4 zeigt die Schaltung eines CMOS-Inverters. Dieser CMOS-Inverter besteht aus einem n-Kanal-Schalttransistor 71 und einem p-Kanal-Lasttransistor 72. Liegt die Eingangsspannung $V_i$ des Inverters unterhalb der Schwellenspannung des Schalttransistors, so entspricht die Ausgangsspannung $V_o$ des Inverters ihrer Größe nach in etwa der Versorgungsspannung $V_{DD}$. Liegt die Eingangsspannung $V_i$ oberhalb dieser Schwellenspannung, so erreicht die Ausgangsspannung $V_o$ ihrer Größe nach in etwa den Wert Null.

Der Vorteil dieses Inverter-Typs liegt darin, daß die Ausgangskennlinie nicht vom Flächenverhältnis von Schalt- zu Lasttransistor abhängt. Mit CMOS-Invertern können daher nicht nur digitale, sondern auch analoge Schaltungen aufgebaut werden.

Aus CMOS-Invertern können Ringoszillatoren gebildet werden, die den auf den druckempfindlichen Bereich des Halbleiter-Sensors wirkenden Betrag des Druckes in ein dem Druck entsprechendes Frequenzsignal umwandeln.

Die Schaltung von CMOS-Invertern in Ringoszillatoren ist z.B. im Buch "Mc MOS Handbook" der Motorola Inc., Semiconductor Products Division, 1973, Kapitel 8, "Analog Basic Circuits", beschrieben.

Die Erfindung läßt sich bei Halbleiter-Sensoren, welche den auf einen bestimmten Teil ihrer Oberfläche wirkenden Betrag des Druckes in ein dem Druck entsprechendes Frequenzsignal umwandeln, auch so benutzen, daß im druckempfindlichen Bereich dieser Halbleiter-Sensoren ausgebildete MIS-Transistoren als frequenzbestimmende Widerstände in bekannten Oszillatorschaltungen Verwendung finden, wobei einfache Schaltungen und hohe Druckempfindlichkeit erzielt werden.

**Patentansprüche**

1. Halbleiter-Sensor mit mehreren MIS-Transistoren, bei dem ein vorbestimmter Teil seiner Oberfläche als druckempfindlicher Bereich ausgebildet ist und bei dem wenigstens ein MIS-Transistor in diesem Bereich zur Umwandlung eines Druckes in ein elektrisches Signal vorgesehen ist, dadurch gekennzeichnet, daß im druckempfindlichen Bereich mehrere MIS-Transistoren so angeordnet sind, daß sie paarweise zu Invertern geschaltet sind und daß eine ungerade Anzahl von diesen Invertern einen Ringoszillator bildet, der den Betrag des Druckes in ein dem Druck entsprechendes Frequenzsignal umwandelt.

2. Halbleiter-Sensor nach Anspruch 1, dadurch gekennzeichnet, daß mehrere Ringoszillatoren im druckempfindlichen Bereich so angeordnet sind, daß die vom jeweiligen Betrag des Druckes abhängigen Frequenzänderungen unterschiedliches Vorzeichen aufweisen.

3. Halbleiter-Sensor nach einem der Ansprüche 1 oder 2, dadurch gekennzeichnet, daß außerhalb des druckempfindlichen Bereichs ein weiterer Ringoszillator entsprechend Anspruch 1 angeordnet ist, dessen Ausgangsfrequenz als Referenzgröße für die Auswertung der druckabhängigen Frequenzen verwendet wird.

4. Halbleiter-Sensor nach einem der vorhergehenden Ansprüche, dadurch gekennzeichnet, daß die zugehörige Schaltung in integrierter Technik ausgeführt ist.

5. Halbleiter-Sensor nach einem der vorhergehenden Ansprüche, dadurch gekennzeichnet, daß auf der Oberfläche des Halbleiter-Sensors Schaltungen in integrierter Technik vorhanden sind, die die Frequenz(en) des bzw. der Ringoszillators(en) in einen vom Anwender gewünschten Frequenzbereich umsetzen.

6. Halbleiter-Sensor nach einem oder einer Kombination von vorhergehenden Ansprüchen, dadurch gekennzeichnet, daß er ein Silizium-Sensor ist und daß er in Silizium-Gate-Technik ausgeführt ist.

**Claims**

1. A semiconductor sensor comprising a plurality of MIS-transistors, where a predetermined part of its surface represents a pressure-sensitive zone and at least one MIS-transistor in this zone serves to convert a pressure into an electrical signal, characterised in that in the pressure-sensitive zone a plurality of MIS-transistors are arranged connected in pairs to form inverters and an odd number of these inverters form a ring oscillator which converts the pressure magnitude into a corresponding frequency signal.

2. A semiconductor sensor as claimed in Claim 1, <u>characterised in that</u> a plurality of ring oscillators are arranged in the pressure-sensitive zone such that the frequency changes which depend upon the particular pressure magnitudes have different signs.

3. A semiconductor sensor as claimed in one of Claims 1 or 2, <u>characterised in that</u> outside the pressure-sensitive zone there is arranged a further ring oscillator corresponding to Claim 1, the output frequency of which is used as a reference value for the analysis of the pressure-dependent frequencies.

4. A semiconductor sensor as claimed in one of the preceding Claims, <u>characterised in that</u> the associated circuitry is designed in integrated technology.

5. A semiconductor sensor as claimed in one of the preceding Claims, <u>characterised in that</u> circuits designed in integrated technology are arranged on the surface of the semiconductor sensor and convert the frequency (frequencies) of the ring oscillator(s) into a frequency range required by the user.

6. A semiconductor sensor as claimed in any one or more of the preceding Claims, <u>characterised in that</u> it is a silicon sensor designed using silicon gate technology.

## Revendications

1. Capteur à semi-conducteurs comprenant plusieurs transistors MIS, sur lequel une partie prédéterminée de la surface du capteur est réalisée comme une zone sensible à la pression et sur lequel au moins un transistor MIS est prévu dans cette zone pour convertir une pression en un signal électrique, caractérisé en ce que plusieurs transistors MIS sont disposés dans la zone sensible à la pression en étant connectés par paires pour former des inverseurs et qu'un nombre impair de ces inverseurs constitue un oscillateur annulaire qui convertit la grandeur de la pression en un signal de fréquence correspondant à la pression.

2. Capteur selon la revendication 1, caractérisé en ce que plusieurs oscillateurs annulaires sont disposés de telle manière dans la zone sensible à la pression que les variations de fréquence, dépendantes de la grandeur instantanée de la pression présentent des signes différents.

3. Capteur selon la revendication 1 ou 2, caractérisé en ce qu'un oscillateur annulaire supplémentaire, selon la revendication 1, est disposé en dehors de la zone sensible à la pression, dont la fréquence de sortie est utilisée comme grandeur de référence pour l'exploitation des fréquences fonction de la pression.

4. Capteur selon une des revendications précédentes, caractérisé en ce que le circuit qui y est associé est réalisé selon la technique d'intégration.

5. Capteur selon l'une des revendications précédentes, caractérisé en ce que la surface du capteur présente des circuits réalisés selon la technique d'intégration et qui transforment la fréquence de l'oscillateur annulaire, ou les fréquences des oscillateurs annulaires, en une gamme de fréquences désirée par l'utilisateur.

6. Capteur selon l'une des revendications précédentes ou une combinaison de celles-ci, caractérisé en ce qu'il est formé par un capteur au silicium réalisé selon la technique des grilles de silicium.

FIG 1

FIG 2

FIG 4

# FIG 3